# EUROPEAN PATENT APPLICATION

(11) **EP 1 788 613 A2**
(43) Date of publication of application: **23.05.2007**
(21) Application number: 06005290.9
(22) Date of filing: 15.03.2006
(51) Int. Cl.: H01J 37/26

(54) **Method of observing live cells under electron microscope**

(30) Priority: 26.10.2005 CN 200510114167
(71) Applicant: Lee, Bing-Huan, Niaosong Township Kao hsiung 833 (TW)
(72) Inventor: Chao, Chih-Yu, Da-an District, Taipei City 106 (TW); Hsieh, Wen-Jiunn, Jhonghe City Taipei County 235 (TW)
(74) Representative: Becker Kurig Straus

(57) **Abstract**

A method of observing a live unit under an electron microscope includes the steps of (A) preparing a live environment inside the electron microscope, wherein the live environment is provided with at least one live unit and a predetermined environmental condition keeping basic physiology of the live unit functional, at least one pair of view windows is located opposite to each other, and the live unit includes at least two objects that can bear different critical charge densities respectively; and (B) irradiating the live unit with a particle beam of predetermined intensity through the view windows, and then display the live unit on an imaging device of the electron microscope, wherein the product of the predetermined intensity of the particle beam and the predetermined duration equals the predetermined charge density that is smaller than or equal to the critical charge density of the object of the live unit.

## Description

### BACKGROUND OF THE INVENTION

### 1. Field of the Invention

The present invention relates generally to the operation technology of electron microscope, and more particularly, to a method of observing a live unit under an electron microscope.

### 2. Description of the Related Art

As known in prior art, while a conventional electron microscope is operated to observe an object, the object has to be a nonvolatile solid for further microscopic observation because of the limitation of the vacuum environment of the specimen chamber inside the electron microscope. If the object is volatile, such as liquid, gas, or other fluid, the object will generate a great amount of gas upon after being put into the vacuum specimen chamber, and thus, not only the electron beam of the electron microscope will fail to penetrate the object for successful imaging or experiment of electron diffraction, but also high-vacuum area, like electron beam gun, will lower its vacuum level or cause contamination therein, further damaging the microscope.

Limited to the vacuum environment, the conventional electron microscope could be operated for observation of structure of solid substance inside the specimen chamber or for observation of dehydrated biological tissues only, like dehydrated cells, bacteria, or viruses, neither for observation of any cell, bacterium, virus or the like having physiological functions under the fluid specimen or environment, absolutely nor for observation of biochemical reaction processes, like transcription between deoxyribonucleic acid (DNA) and ribonucleic acid (RNA) inside the nucleus and translation between RNA and protein, microtubules inside the cytoplast, and of any vital phenomenon, like physiology of transduction at neuromuscular junctions.

In addition, if the radioactive ray or the electron beam irradiates the live cell or tissue with a predetermined charge density (exposure intensity times irradiation time) and the charge density is larger than the critical charge density that the live cell or tissue hardly survives, the live cell or tissue will die or be disabled and fail to maintain its original functions. Excessive charge density may even destroy the live cell or tissue to decompose the same.

Therefore, there must be a device that the live cell or tissue could be put therein and the device could be put into the specimen chamber of the electron microscope for observation, and the operation method must avoid the aforementioned circumstances that the live cell or tissue may get hurt.

In view of above, after successive trials and experiments, the present invention is invented to improve the aforementioned drawbacks of the prior art and to enable observation of the live cells or other live objects.

### SUMMARY OF THE INVENTION

The primary objective of the present invention is to provide a method of observing a live unit under an electron microscope that enables the observation of the live unit inside a live environment under the electron microscope. The live unit can be a live cell, a live tissue, substance inside the live cell, or substance between the live cells.

The secondary objective of the present invention is to provide a method of observing a live unit under an electron microscope that enables the observation of the live unit under the electron microscope without hurting or disabling the live unit.

The foregoing objectives of the present invention are attained by the method including the following steps.
A. Prepare a live environment inside a specimen chamber of an electron microscope. The live environment is provided with at least one live unit and a predetermined environmental condition keeping basic physiology of the live unit functional. At least one pair of view windows are located opposite to each other at an upper side and a lower side of the live environment respectively. The live unit includes at least two objects that can bear different critical charge densities respectively.
B. Irradiate the live unit within its predetermined area with a particle beam of predetermined intensity through the view windows for predetermined duration, and then display the live unit on an imaging device of the electron microscope. The product of the predetermined intensity of the particle beam and the predetermined duration equals the predetermined charge density that is smaller than or equal to the critical charge density of the object of the live unit within the predetermined area under the irradiation.

As indicated above, the present invention enables the user not only to observe the live unit under the electron microscope but also to do so without hurting the live unit.

### BRIEF DESCRIPTION OF THE DRAWINGS

FIG 1 is a first operational view of a preferred embodiment of the present invention.
FIG 2 is a schematic view of the preferred embodiment of the present invention, illustrating the operating status of an energy filter.
FIG 3 is a second operational view of the preferred embodiment of the present invention.
FIG. 4 is a schematic view of the preferred embodiment of the present invention, showing an alternative structure of the live environment.
FIG. 5 is a third operational view of the preferred embodiment of the present invention.
FIG 6 is a fourth operational view of the preferred embodiment of the present invention.

### DETAILED DESCRIPTION OF PREFERRED EMBODIMENTS

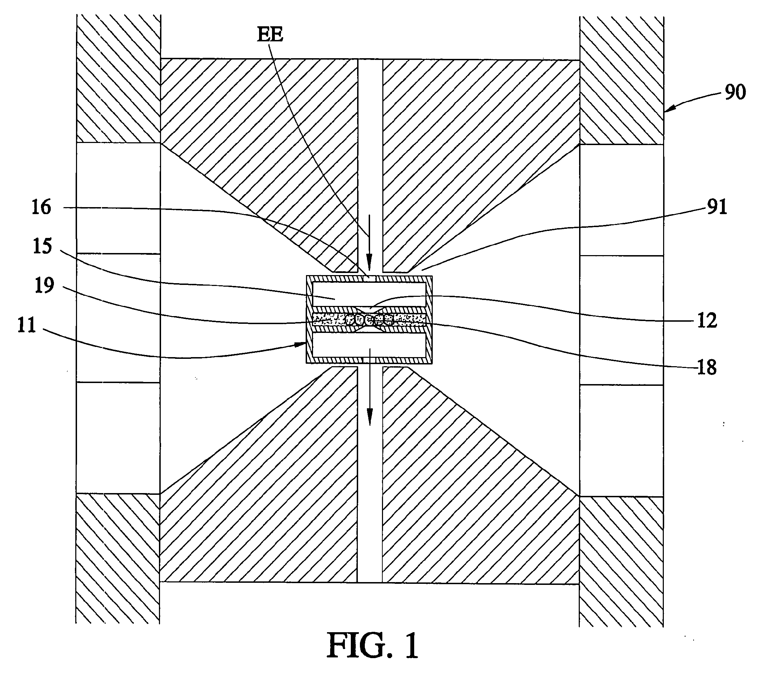

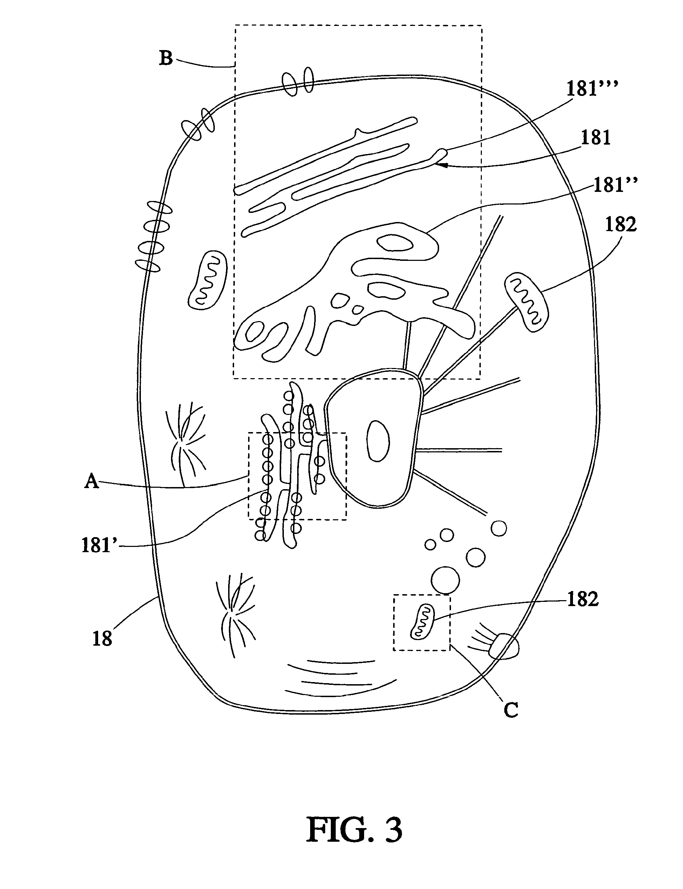

Referring to FIGS. 1-3, a method of observing a live unit under an electron microscope includes the following steps.
A. Prepare a live environment 11 inside a specimen chamber 91 of an electron microscope 90. The live environment 11 is provided with at least one live unit 18 and a predetermined environmental condition 19. The predetermined environmental condition 19, such as a gas of a predetermined pressure, a vapor of a predetermined pressure, a liquid of a predetermined pressure, or an admixture of them, keeps basic physiology of the live unit functional. The live environment 11 is a box-like member in this embodiment. At least one pair of view windows 12 are located opposite to each other at a top side and a bottom side of the live environment respectively, each embodied as an opening with its diameter of 5-100µm. Two buffer layers 15 are formed at an upper side and a lower side of the live environment 11 respectively. A pair of outer apertures 16 are formed at a top side of the upper buffer layer 15 and at a bottom side of the lower buffer layer 15 respectively and are coaxial with the two view windows 12. The live unit 18 includes at least two objects 181 which can bear different critical charge densities respectively. If a charge density applied to the object 181 is larger than the critical charge density that each of the objects 181 hardly survive, the object 181 will be disabled or die. The disability of the object 181 indicates that the object 181 fails to function anymore; for example, if the chromosome is disabled, it will fail to do cell division.
B. Irradiate the live unit 18 within its predetermined area with a particle beam EE of predetermined intensity through the view windows 12 and the outer apertures 16 for predetermined duration, and then display the live unit 18 on an imaging device (not shown) of the electron microscope 90. The product of the predetermined intensity of the particle beam EE and the predetermined duration equals the predetermined charge density that is smaller than or equal to the critical charge density of the object 181 of the live unit 18 within the predetermined area under the irradiation. In this embodiment, there can be many/predetermined times (e.g. 30-50) of the irradiation, each of which is done within predetermined area for predetermined duration, and then for imaging. The total sum of the charge density of the irradiation of the predetermined times with subtraction of the charge density neutralized by the environmental condition still has to be smaller than or equal to the critical charge density of the object 181 of the live unit 18 within the predetermined area under the irradiation. In a section A shown in FIG 3, the rough endoplasmic reticulum (ER) 181' inside the cell is observed. In a section B shown in FIG. 3, the smooth ER 181 " and the Golgi complex 181''' are observed at the same time. When there are at least two objects 181 within the predetermined area under the irradiation, it still has to be controlled that the total sum of the charge density of the irradiation of the predetermined times with subtraction of the charge density neutralized by the environmental condition is still smaller than or equal to the critical charge density of the object 181 of the live unit 18, which can bear the smallest critical charge density, within the predetermined area under the irradiation.

For example, while the mitochondrion 182 of one cell is observed as shown in a section C of FIG 3, the total sum of the charge density of the irradiation with subtraction of the charge density neutralized by the environmental condition still cannot be larger than the critical charge density of the mitochondrion 182, and otherwise, the mitochondrion 182 would be disabled.

The aforementioned live unit 18 can alternatively be a live cell, a bacterium, a virus, a morphon having live physiology, or the combination of them. The object 181 located inside, outside, or at a surface of the live unit 18 can alternatively be nucleus, cytoplasm, organelle, or enzyme inside the cell. The organelle includes chromosome, protein, mitochondrion, or any other object that a common cell has.

The aforementioned particle beam EE can alternatively be electron beam, ion beam, atom beam, or neutron beam.

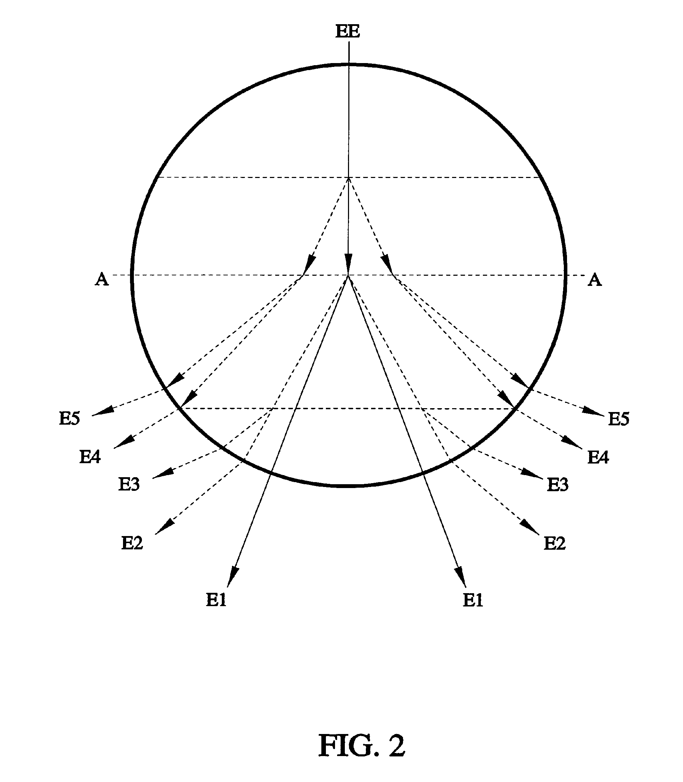

In addition, while imaging, the imaging methods, like dark field imaging, differential interference contrast (DIC), and image plate (IP) imaging, are available for generating high-contrast and high-resolution images in very short duration of exposure and can be applied to the present invention to prevent the live unit 18 and the objects 181 from disability and death resulted from the irradiation of the particle beam and to further get rid of the problem that the imaging may defocus due to cellular Brownian Motion. Moreover, alternative imaging methods, like annular dark-field (ADF) and high-angle annular dark-field detector (HAADF) combined with an energy filter, and electron energy loss spectroscopic (EELS) analyzer, can be applied to capture predetermined particle energy E1 for achieving higher-resolution imaging quality; for example, the particle energy which is not scattered from an imaging section A-A (FIG. 2) can be filtered out, background signals of the live unit, such as background noises of water molecules, can be filtered out to enhance the imaging resolution, and specific particles of scattering energy can be tracked. The operation of the energy filter is as shown in FIG 2.

The aforementioned electron microscope 90 can alternatively be a transmission electron microscope (TEM) or a scanning transmission electron microscope (STEM). Capturing specific energy particles for imaging under the STEM with the imaging methods of ADF and HAADF by means of an electron energy loss spectrometer (EELS) analyzer or an energy filter can enable observation of thicker live unit (5-10µm) to achieve higher-resolution imaging quality for the observation.

As indicated in the aforementioned method of the present invention, the environmental condition 19 inside the live environment 11 can alternatively be an admixture of water vapor of a predetermined pressure (or saturated water vapor of one atmospheric pressure) and specific gases like nitrogen, oxygen, carbon dioxide, and inert gas, or a low-pressure liquid. As a matter of fact, the view windows 12 each having a small diameter can limit the rate that the gas or liquid of the environmental condition 19 slowly escapes to the buffer layers 15, and pumping out the buffer layers 15 can prevent the vapor and the specific gas from escaping into the specimen chamber 91. In addition, the imaging methods like ADF, HAADF, energy filter, and EELS analyzer can capture specific particles for imaging to render high-contrast and high-resolution images.

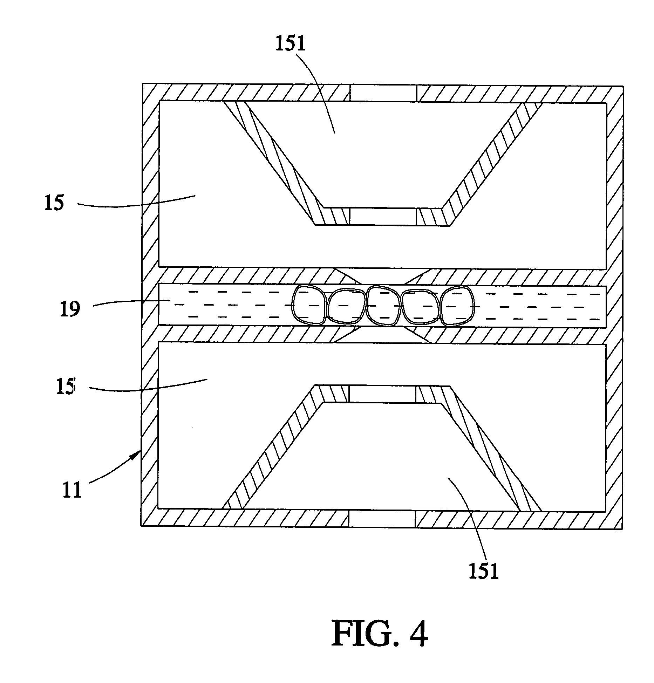

Referring to FIG 4, while the live environment 11 requires a liquid physiological environment, such as a liquid environment under one atmospheric pressure, each of the two buffer layers 15 outside the live environment 11 can alternatively be partitioned to form a compartment 151 located therein, for providing a gas of predetermined pressure such as an admixture of saturated or unsaturated water vapor and a specific gas with a total sum of one atmospheric pressure, wherein the specific gas can be nitrogen, oxygen, carbon dioxide, or an inert gas. The buffer layers 15 are provided with pressure of saturated water vapor for suppressing the evaporation rate of the water solution inside the live environment 11. The buffer layers 15 can alternatively be provided with the specific gas of one atmospheric pressure. Control that pressure difference between the specific gas and the water solution inside the live environment 11 to be smaller than or equal to the critical leakage pressure of the water-gas interface between the water solution and the gas so as to prevent the water solution inside the live environment 11 from flowing out of the view windows 12 but to enable the water solution to be vaporized slowly into the buffer layers 15. While the compartment 151 keeps being pumped out, the vapor and gas escaped from the buffer layers 15 into the compartment 151 is evacuated not to escape into the specimen chamber 91, thus providing a liquid environment of physiology for live unit.

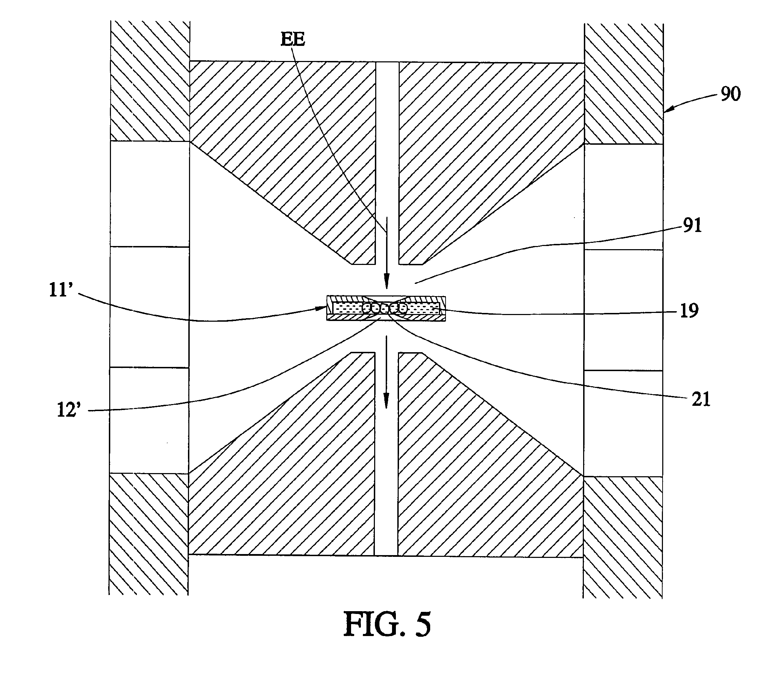

Referring to FIG 5, while the present invention is operated, an amorphous film layer, like silicon dioxide, polymer, or amorphous carbon film, is sealed to the view windows 12' of the live environment 11' for isolating the environmental condition 19 from outside. In light of this, even without mounting the aforementioned buffer layers 15, the fluid of the environmental condition 19 inside the live environment 11' does not escape or is not vaporized outwards. In the meantime, a cell attachment layer, like poly-L-lysine, poly-L-arginine, poly-hydroxyethyl-methacrylate (PHEMA), or a copolymer made of them, is adhered to a surface of the film 21 to get rid of the cellular Brownian Motion. In addition, the imaging methods of energy filter, EELS, ADF, and HAADF can overcome the drawback that the imaging resolution is declined due to the thicker film 21 generating some inelastic electron scattering.

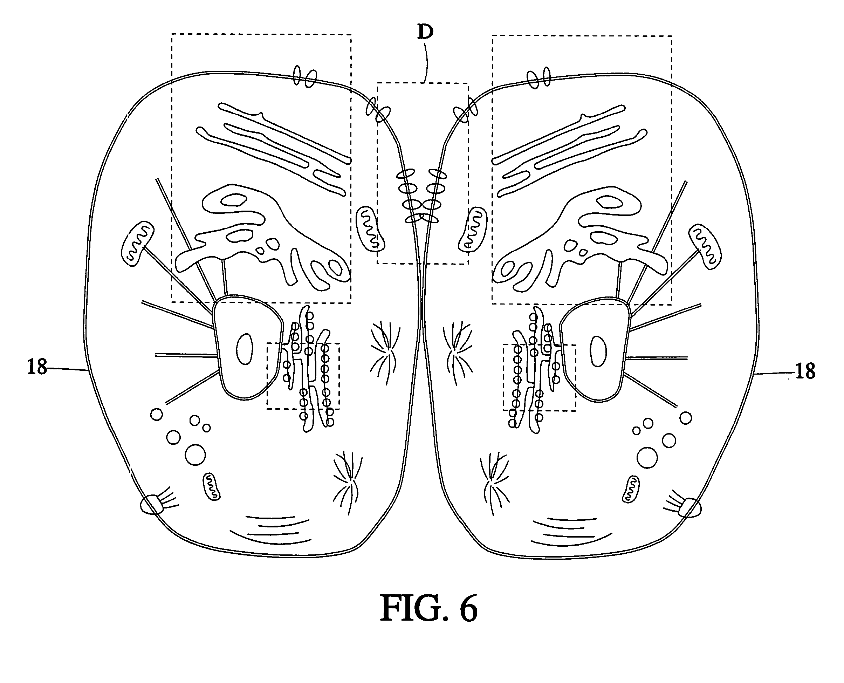

FIG. 6 shows that two cells are observed, wherein a section D enables observation of any intracellular, extracellular, or intercellular substance.

As indicated above, the method of the present invention discloses that the user can operate the electron microscope to observe the live unit.

Meanwhile, the present invention also discloses that the live unit can be observed under the electron microscope without hurting the live unit.

Although the present invention has been described with respect to a specific preferred embodiment thereof, it is no way limited to the details of the illustrated structures but changes and modifications may be made within the scope of the appended claims.

## Claims

1. A method of observing a live unit under an electron microscope, comprising the steps of:
(A) preparing a live environment inside a specimen chamber in an electron microscope, said live environment being provided with at least one live unit and a predetermined environmental condition, said predetermined environmental condition keeping basic physiology of said live unit functional, at least one pair of view windows being located opposite to each other at an upper side and a lower side of said live environment respectively, said live unit having at least two objects can bear different critical charge densities respectively; and
(B) irradiating said live unit within its predetermined area with a particle beam of predetermined intensity through said view windows for predetermined duration, and then display said live unit on an imaging device of said electron microscope, wherein a product of the predetermined intensity of the particle beam and the predetermined duration equaling said predetermined charge density that is smaller than or equal to said critical charge density of the object of said live unit within said predetermined area under the irradiation.

2. The method as defined in claim 1, wherein in step (A), if a charge density applied to said object is larger than said critical charge density that said object hardly survives, said object will be disabled or die.

3. The method as defined in claim 1, wherein in step (B), said live unit is irradiated for predetermined times, each of which the irradiation is done within predetermined area of said live unit for the predetermined duration.

4. The method as defined in claim 1, wherein in step (B), a total sum of the charge density of the irradiation of the predetermined times with subtraction of the charge density neutralized by the environmental condition is smaller than or equal to the critical charge density of said object of said live unit within the predetermined area under the irradiation; while said live unit has at least two objects within the predetermined area under the irradiation, a total sum of the charge density of the irradiation of the predetermined times is smaller than or equal to the critical charge density of any of said at least two objects, which can bear the smallest critical charge density, within the predetermined area under the irradiation.

5. The method as defined in claim 1, wherein said live unit is a live cell, a bacterium, a virus, or a combination of them.

6. The method as defined in claim 5, wherein each of said objects is located inside, outside, or at a surface of said live unit.

7. The method as defined in claim 5, wherein each of said objects is an intracellular nucleus, cytoplast, organelle, or enzyme, said organelle having chromosome, protein, or mitochondrion.

8. The method as defined in claim 1, wherein said live environment is formed of a box-like member; each of said view windows is an opening and formed at a top side and a bottom side of said live environment respectively.

9. The method as defined in claim 8, wherein said environmental condition is a vapor of a predetermined pressure, a gas of a predetermined pressure, a liquid of a predetermined pressure, or an admixture of them.

10. The method as defined in claim 8, wherein each of said view windows has a diameter of 5-100µm; said live environment further has at least one buffer layer and at least one pair of outer apertures, said at last one buffer layer being formed outside said live environment, said outer apertures being formed at a top side and a bottom side of said buffer layer respectively, said outer apertures being coaxial with said view windows.

11. The method as defined in claim 8, wherein said at least one view window is sealed by a film.

12. The method as defined in claim 1, wherein said particle beam is an electron beam, an ion beam, an atom beam, or a neutron beam.

13. The method as defined in claim 1, wherein in step A, said electron microscope is a transmission electron microscope (TEM) or a scanning transmission electron microscope (STEM).

14. The method as defined in claim 13, wherein in step B, said live unit can be visualized by alternative imaging methods, like dark field imaging, energy filter, and electron energy loss spectroscopy, for capturing predetermined particles for better imaging quality.
